## Europäisches Patentamt
## European Patent Office
## Office européen des brevets

(19)

(11) Numéro de publication: **0 015 830**
**B1**

(12) **FASCICULE DE BREVET EUROPEEN**

(45) Date de publication du fascicule du brevet: **15.09.82**

(51) Int. Cl.³: **G 01 M 11/00, H 01 S 3/10**

(21) Numéro de dépôt: **80400277.2**

(22) Date de dépôt: **28.02.80**

(54) **Appareillage de mesure du module de la fonction de transfert d'une fibre optique et son utilisation.**

(30) Priorité: **02.03.79 FR 7905543**

(43) Date de publication de la demande:
**17.09.80 Bulletin 80/19**

(45) Mention de la délivrance du brevet:
**15.09.82 Bulletin 82/37**

(84) Etats contractants désignés:
**DE GB NL**

(56) Documents cités:
**FR - A - 2 296 842**

**OPTICS COMMUNICATIONS, vol. 25, no. 1, avril 1978 Amsterdam NL D. KECK et al.: "Measurements on high bandwidth optical waveguides" pages 43—48**

**APPLIED OPTICS, vol. 17, no. 1, janvier 1978 New York US M. IKEDA et al.: "Transfer function of long spliced graded index fibers with mode scramblers", pages 63—67**

(73) Titulaire: **Pophillat, Lucien Croix Rolland Rospez F-22300 Lannion (FR)**
(73) Titulaire: **Moalic, Jean 40, Avenue d'Alsace F-22300 Lannion (FR)**
(73) Titulaire: **Sorel, Yvon Kernu, Louannec F-22700 Perros Guirec (FR)**

(72) Inventeur: **Pophillat, Lucien Croix Rolland Rospez F-22300 Lannion (FR)**
Inventeur: **Moalic, Jean 40, Avenue d'Alsace F-22300 Lannion (FR)**
Inventeur: **Sorel, Yvon Kernu, Louannec F-22700 Perros Guirec (FR)**

(74) Mandataire: **Martinet, René et al, Cabinet Martinet 62, rue des Mathurins F-75008 Paris (FR)**

Courier Press, Leamington Spa, England.

(56) Documents cités:

RCA REVIEW, vol. 35, no. 2, juin 1974
Princeton US
J. WITTKE: "Dispersion-limited modulation
bandwidths of optical fibers", pages 198—215

ELECTRONICS AND COMMUNICATIONS IN
JAPAN, vol. 60-C, no. 4, avril 1977
Tokyo JP
I. KOBAYASHI et al.: "Measurement of optical
fiber transfer functions by swept-frequency
technique and discussion of fiber
characteristics" pages 126—133

Appareillage de mesure du module de la fonction de transfert d'une
fibre optique et son utilisation.

La présente invention concerne un appareillage de mesure du module de la fonction de transfert d'une fibre optique, comprenant des moyens pour générer un premier signal électrique à fréquence variable, des moyens d'émission laser pour convertir le premier signal électrique en un signal lumineux modulé par la fréquence variable et propre à être transmis au cours d'une phase dite de mesure à travers ladite fibre optique, une fibre optique amorce dont l'extrémité d'entrée reçoit le signal lumineux transmis par les moyens d'émission laser et dont la longueur est telle que le signal lumineux transmis par son extrémité de sortie soit dans les conditions d'équilibre de couplage de modes, des moyens de photodétection pour convertir le signal lumineux en un signal électrique à ladite fréquence variable et des moyens d'analyse du spectre du second signal électrique qui permetent de visualiser le module de la fonction de transfert de la fibre optique par mesure de la puissance du second signal électrique en fonction de ladite fréquence variable de modulation. Elle a trait également à l'utilisation de cet appareillage dans une forme de realisation préférée.

Un tel appareillage de mesure dans lequel les moyens de génération du premier signal électrique à fréquence variable incluent un vobulateur, est décrit dans la contribution No 208, groupe d'étude XV, du Comité Consultatif International Télégraphique et Téléphonique (C.C.I.T.T.) publiée en Octobre 1978 et intitulée "Consideration on transmission characteristics measurements method of optical fibres".

Le premier signal électrique est un signal dont la fréquence varie continûment et cycliquement. Il est transmis à la diode laser qui le convertit en un signal lumineux porteur modulé par la fréquence de vobulation et émis à travers la fibre optique à mesurer vers un photodétecteur.

Lors de la phase d'étalonnage, c'est-à-dire lorsque la diode laser est directement couplée optiquement avec le photodétecteur sans l'intermédiaire de la fibre optique, une courbe de réponse est mémorisée dans les moyens d'analyse spectrale en vue de servir de référence à la mesure ultérieure de la fonction de transfert de la fibre optique. Cette courbe de réponse de référence n'est pas une fonction constante indépendante de la bande de fréquence de vobulation, car elle est dépendante des fonctions de transfert propres de la diode laser et du photodétecteur. Par conséquent, lors de la phase de mesure pour laquelle la fibre optique est insérée entre la diode laser et le photodétecteur, il est nécessaire d'effectuer la différence, relativement à la puissance du second signal électrique transmis par le photodétecteur aux moyens d'analyse spectrale, entre la courbe de réponse de référence mémorisée et la courbe de réponse obtenue au cours de la phase de mesure pour déduire la fonction de transfert de modulation propre de la fibre optique. Ce procédé de mesure ne tient pas compte des conditions optimales d'injection du signal lumineux dans la fibre optique à mesurer. Ces conditions d'injection sont relatives au couplage des modes du signal lumineux qui est équilibré normalement dans une fibre optique après transmission dans celle-ci sur une grande longueur. Par suite le diagramme de rayonnement du signal lumineux injecté à l'entrée de la fibre optique à mesurer n'étant pas égal au diagramme de rayonnement d'équilibre de la fibre optique implique que la mesure selon le procédé précité ne donne pas une connaissance exacte de la fonction de transfert propre de la fibre optique.

Par ailleurs, on notera que l'appareillage selon le procédé de mesure par vobulation nécessite que le signal à la fréquence de balayage du vobulateur soit transmis par l'intermédiaire d'un conducteur électrique annexe vers les moyens d'analyse spectrale. Ceci exclut des mesures relatives à une fibre optique de grande longueur, telles que celles relatives à la pose d'un câble à fibres optiques en chantier, pour lesquelles les extrémités d'entrée et de sortie de la fibre optique ne sont pas voisines ou dans un même local.

L'article de J. WITTKE publié dans "RCA Review", vol. 35, No. 2, Juin 1974, Princeton (US), décrit notamment aux pages 205 et 206, un appareillage de mesure du type de celui divulgué dans la contribution No. 208 du C.C.I.T.T. précitée. Selon cet article, il est prévu d'introduire au cours de la phase d'étalonnage une fibre optique de longueur courte, de l'ordre de 6 mètres, entre la diode laser et le photodétecteur. Cette fibre courte ne modifie pas pratiquement la réponse en fréquence de l'appareillage. La phase d'étalonnage est destinée à calibrer la réponse en fréquence avant la phase de mesure de la fibre optique à étudier afin d'éliminer les erreurs de mesure introduites par les caractéristiques en fréquence de la diode laser et du photodétecteur. Là encore, les conditions d'injection pour l'équilibre des modes à l'entrée de la fibre optique à mesurer ne sont pas considérées. Les mesures nécessitent également une calibration du premier signal électrique dans les moyens d'analyse du spectre par connexion à ceux-ci de la sortie du générateur de ce signal avant toute mesure.

L'article de M. IKEDA et al. publié dans "Applied Optics" pages 63 à 67, vol. 17, No. 1, Janvier 1978, New York (US), fait également appel à un troisième appareillage de mesure de la fonction de transfert analogue aux deux précédents. Ce troisième appareillage inclut un simulateur d'équilibre de modes ou dit également brouilleur de modes sous la forme d'une fibre optique qui présente des microcourbures et qui est disposé à la suite de la diode laser.

D'autres appareillages et procédés connus pour mesurer la fonction de transfert d'une fibre optique sont fondés sur la réponse impulsionnelle de la fibre optique. Dans ce cas, les moyens de génération du premier signal électrique modulant l'émission laser comportent un générateur d'impulsions courtes à fréquence variable. Les procédés de mesure, côté réception, sont fondés sur l'analyse temporelle ou sur l'analyse spectrale d'une impulsion lumineuse transmise par la fibre optique. De tels procédés et appareillages sont décrits dans la communication V.1, pages 123 à 134, du Deuxième Colloque Européen sur les transmissions par fibres optiques, septembre 1975 et pour ce qui concerne l'analyse spectrale, dans l'article de D. KECK et al., pages 43 à 48, Vol. 25, No. 1, de la revue "Optics Communications", Avril 1978, Amsterdam (NL), et également dans le brevet FR—B—2 296 842.

Selon le procédé d'analyse temporelle, la dynamique de mesure est réduite et la précision dépend de la finesse de l'impulsion transmise à l'entrée de la fibre optique. Ce procédé nécessite de puissants moyens de calcul pour obtenir la fonction de transfert, relativement imprécise, de la fibre optique.

La puissance faible contenue dans chaque raie spectrale, surtout aux fréquences élevées, limite également la précision de la fonction de transfert mesurée selon le procédé d'analyse spectrale.

Par contre, certains appareillages (voir les articles précités de M. IKEOA et al., page 63 (second selon et troisième procédés) et de D. KECK et al.) tiennent compte de l'obtention d'un état d'équilibre du couplage des modes à l'entrée de la fibre optique. A cet égard, un simulateur d'équilibre de modes est interconnecté optiquement entre la diode laser et l'extrémité d'entrée de la fibre optique á mesurer. Ce simulateur peut être obtenu en comprimant les premiers vingts centimètres de la fibre optique à mesurer ou d'une fibre amorce courte entre de la toile émeri et une plaque d'élastomère ce qui impose à la fibre des microcourbures aléatoires qui induisent un fort couplage des modes. Selon une autre variante, le simulateur est réalisé par une fibre optique amorce qui est de même nature que la fibre optique à mesurer et interconnectée optiquement entre la diode laser et la fibre optique à mesurer. La longueur de la fibre optique amorce est grande, de l'ordre du kilomètre, afin que la distribution irrégulière des modes de propagation devant la diode laser, à l'entrée d'injection de la fibre optique amorce, devienne progressivement homogène au fur et à mesure que l'on s'en éloigne. Par suite, un état d'équilibre est obtenu avant l'extrémité de sortie de la fibre amorce et, corollairement, au moins au niveau de l'extrémité d'entrée de la fibre optique à mesurer.

L'utilisation de tous les appareillages connus précédents font donc appel soit à la différence de deux courbes de réponse en fréquence dont l'une est préalablement enregistrée, soit à des moyens de calcul complexes, pour obtenir le module de la fonction de transfert d'une fibre optique. En outre, aucun de ces appareillages ne permet de sélectionner un nombre déterminé de fréquences discrètes prédéterminées afin de notamment les mélanger simultanément et ainsi d'étudier les caractéristiques de la fibre optique dans les véritables conditions de son utilisation ultérieure.

La présente invention a pour but de pallier aux inconvénients précédents afin que le module de la fonction de transfert de la fibre optique soit mesuré pour une répartition discrète de fréquences prédéterminées mélangées en un signal à multifréquence ou en un signal à multiplexage temporel de fréquences et soit obtenu directement sur l'écran des moyens d'analyse du spectre après une phase d'étalonnage éliminant dans la mesure ultérieure notamment l'influence des fonctions des transfert propres aux éléments constitutifs de l'appareillage localisés sur le chemin de transmission du signal lumineux.

A cette fin, l'appareillage de mesure du module de la fonction de transfert d'une fibre optique tel que défini au début de la description est caractérisé en ce que lesdits moyens de génération du premier signal électrique à fréquence variable comprennent une pluralité d'oscillateurs qui transmettent chacun aux moyens d'émission laser un signal sinusoïdal à une fréquence composante prédéterminée différente de celles assignées aux autres oscillateurs pour moduler l'émission laser, et des moyens commandés par tension et associés à chaque oscillateur pour régler l'amplitude du signal sinusoïdal transmis par l'oscillateur associé à une amplitude prédéterminée qui correspond à un niveau prédéterminé de toutes les raies de fréquence analysées par lesdits moyens d'anlyse du spectre du second signal électrique au cours d'une phase dite d'étalonnage pour laquelle la fibre optique à mesurer n'est pas incluse dans l'appareillage.

Une forme de realisation préférée de l'appareillage selon l'invention est caractérisé en ce qu'il comprend un premier connecteur dont l'élément d'entrée est connecté à l'extrémité de sortie de la fibre optique amorce et dont l'élément de sortie est abouté en alignement à l'élément d'entrée d'un second connecteur au cours de ladite phase d'étalonnage, ou est connecté à l'extrémité d'entrée de la fibre optique à mesurer au cours de ladite phase de mesure, et ledit second connecteur dont l'élément d'entrée est connecté à l'extrémité de sortie de la fibre optique au cours de ladite phase de mesure et dont l'élément de sortie est positionné en face desdits moyens de photodétection.

L'utilisation de l'appareillage selon la forme de realisation de l'invention mentionnée ci dessus est caractérisé en ce que la phase d'étalonnage comprend l'aboutement aligné de l'élément de sortie du premier connecteur et de l'élément d'entrée du second connecteur en vis-à-vis des moyens de photodétection et l'ajustage au dit niveau prédéterminé des niveaux des raies spectrales qui sont visualisées par les moyens d'analyse de spectre et qui correspondent à des fréquences composantes prédéterminées du premier signal électrique, et en ce que la phase de mesure comprend l'insertion des extrémités d'entrée et de sortie de la fibre optique à mesurer respectivement dans l'élément de sortie du premier connecteur et l'élément d'entrée du second connecteur et la sélection d'un nombre prédéterminé desdites fréquences composantes dans lesdits moyens de génération du premier signal électrique afin que celui-ci soit un signal issu du mélange simultané ou du multiplexage temporel des fréquences composantes sélectionnées.

Ainsi grâce à une phase d'étalonnage au cours de laquelle les niveaux des raies correspondant à la répartition discrète des fréquences prédéterminées sont égalisés à un niveau de puissance prédéterminée pour constituer une courbe de réponse rectiligne indépendante de la fréquence, l'influence des fonctions de transfert de la source laser, de la fibre optique amorce et du photodétecteur ainsi que des deux connecteurs est éliminée dans le résultat de la mesure. La fonction de transfert exacte de la fibre optique est alors directement visualisée sur l'écran d'un analyseur de spectre lors de la phase de mesure, contrairement aux procédés connus selon lesquels il est nécessaire d'effectuer une différence de spectres pour obtenir la fonction de transfert recherchée. Par ailleurs, contrairement au procédé par vobulation, l'influence du déséquilibre du couplage de modes est supprimée par l'interconnexion optique d'une fibre optique amorce de grande longueur entre la source laser et l'entrée de la fibre optique à mesurer.

L'appareillage conforme à l'invention est adapté aussi bien pour des mesures en laboratoire que pour des mesures point-à-point au niveau des connexions d'un câble à fibres optiques. Les mesures peuvent être relatives à une grande gamme de fréquences composantes et à une grande plage de longueurs de fibres optiques à mesurer.

D'autres avantages de la présente invention apparaîtront plus clairement à la lecture de la description qui suit et des dessins annexés correspondants, dans lesquels:

— la figure 1 est un bloc-diagramme schématique de l'appareillage en phase d'étalonnage;

— la figure 2 est un bloc-diagramme schématique de l'appareillage en phase de mesure;

— la figure 3 est un diagramme montrant les courbes de réponse visualisées par l'analyseur de spectre après la phase d'étalonnage et au cours de la phase de mesure; et

— la figure 4 est un bloc-diagramme détaillé du générateur à multifréquence et du circuit d'émission laser.

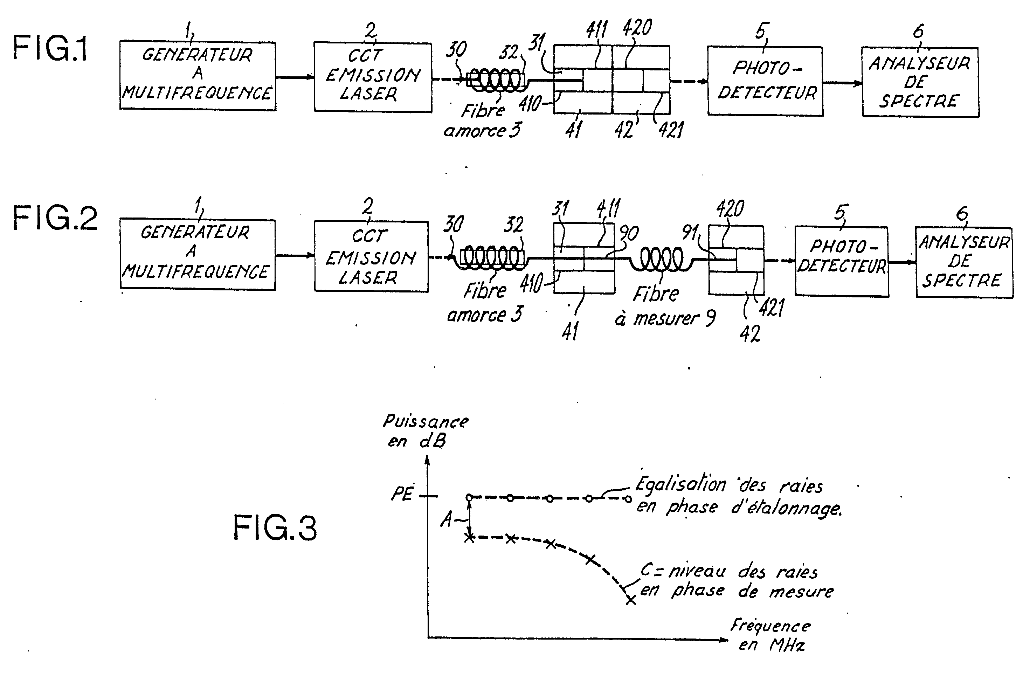

Tel que représenté aux figures 1 et 2, l'appareillage de mesure conforme à l'invention comporte une partie émission située en amont d'une fibre amorce et une partie réception et d'analyse située en aval de la fibre amorce.

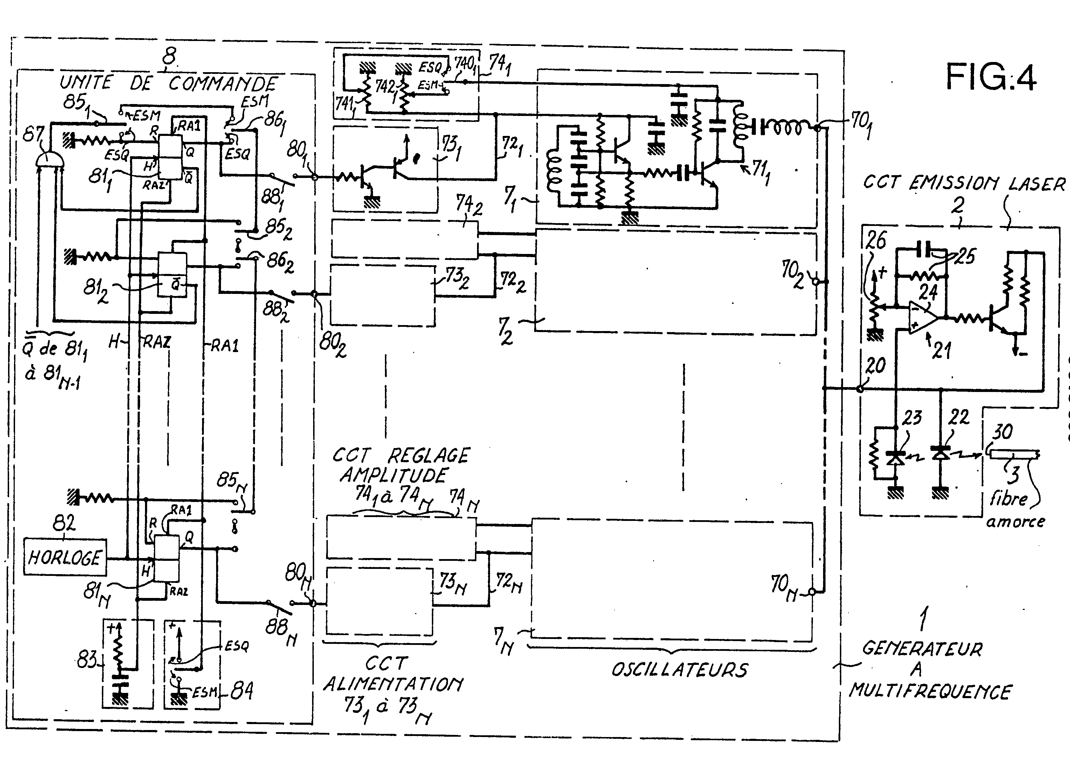

La partie émission comporte un générateur à multifréquence 1 qui génère des signaux sinusoïdaux à fréquences prédéterminées. Ces signaux sont mélangées en fréquence, lorsqu'ils sont émis simultanément, ou sont multiplexés temporellement, lorsqu'ils sont sélectionnés périodiquement, comme cela sera expliqué dans la suite en référence à la figure 4. Le premier signal de tension à multifréquence est transmis par le générateur 1 à un circuit d'émission laser 2 pour moduler une source laser telle qu'une diode laser à fonctionnement continu, polarisée en classe A.

Puis le circuit d'émission laser 2 convertit le premier signal de tension en un signal lumineux à multifréquence qui est injecté à l'extrémité d'entrée 30 d'une fibre optique dite amorce 3 soit directement et classiquement sans précautions particulières, soit en centrant l'axe optique de la diode laser du circuit d'émission laser 2 éventuellement à travers des moyens optiques de collimation et de focalisation (non représentés). La fibre amorce 3 a les mêmes caractéristiques structurelles et dimensionnelles relativement à sa section que celles de la fibre optique à mesurer. La longueur de la fibre amorce 3 est suffisamment longue, de l'ordre d'un kilomètre environ, afin que l'état d'équilibre des modes de propagation convoyés par le signal lumineux soit atteint au plus tard au niveau de l'extrémité de sortie 31 de la fibre amorce 3. La fibre amorce 3 est par exemple enroulée autour d'un tambour 32 qui a un diamètre de 200 mm et une longueur de 100 mm.

L'extrémité de sortie 31 de la fibre amorce 3 est insérée dans un premier embout dit d'entrée 410 d'un premier connecteur pour fibres optiques 41 dont l'autre embout dit de sortie 411 maintiendra, lors de la phase de mesure, l'extrémité d'entrée de la fibre optique à mesurer. Les embouts et connecteurs mis en oeuvre dans la présente invention sont par exemple ceux divulgués dans la demande de brevet DE—B—28 26 032.4—51.

La partie réception et d'analyse de l'appareillage de mesure comporte un second connecteur pour fibres optiques 41 qui transmet directement lors de la phase d'étalonnage, telle que montrée à la figure 1, le signal lumineux à multifréquence à un photodétecteur 5. Le photodétecteur 5 comporte un élément photosensible tel qu'une diode pin qui convertit le signal lumineux reçu en un second signal électrique à multifréquence selon une loi quadratique fonction du rapport de la puissance du second signal électrique de sortie et de la puissance du signal lumineux entrant. Puis le second signal électrique est transmis à un analyseur de spectre 6 qui permet d'analyser et de visualiser la fonction de transfert, c'est-à-dire la puissance électrique reçue par le photodétecteur 5 en fonction de la fréquence, comme montré à la figure 3.

En se référant maintenant à la figure 4, on a détaillé le générateur à multifréquence 1 conforme à l'invention et le circuit d'emission laser 2.

Le générateur à multifréquence 1 comporte essentiellement N oscillateurs $7_1$ à $7_N$ et une unité de commande 8 destinée à commander sélectivement les alimentations des oscillateurs. Chaque oscillateur délivre sur sa borne de sortie $70_1$ à $70_N$ un signal sinusoïdal qui est à une fréquence d'oscillation prédéterminée différente des fréquences assignées aux autres oscillateurs. Cette transmission en sortie du signal sinusoïdal est réalisée à travers un circuit de couplage inductif et capacitif $71_1$ à $71_N$ accordé à la fréquence prédéterminée. Le signal composant est émis lorsque l'entrée d'alimentation $72_1$ à $72_N$ de l'oscillateur $7_1$ à $7_N$ est mise sous tension par l'intermédiaire d'un circuit d'alimentation à deux étages à transistor $73_1$ à $73_N$ qui est initialisé par la sortie associée $80_1$ à $80_N$ de l'unité de commande 8.

L'unité de commande 8 des circuits d'alimentation $73_1$ à $73_N$ est essentiellement constituée par un registre à décalage composé de N bascules bistables $81_1$ à $81_N$. L'entrée d'horloge H de chaque bascule est reliée à une horloge 82 qui produit un signal d'horloge à la fréquence de sélection des circuits d'alimentation des oscillateurs. La période T de ce signal d'horloge correspond à la durée d'émission d'un signal à la fréquence prédéterminée correspondant à un oscillateur $7_1$ à $7_N$ lorsque l'émission séquentielle ESQ des oscillateurs est sélectionnée. Les bascules $81_1$ à $81_N$ sont remises à zéro par leurs entrées RAZ au moyen d'un circuit de réinitialisation 83, lors de la mise sous tension de l'appareillage. L'état des entrées de remise à l'état "1" RA1 des bascules bistables est commandé par un commutateur 84. Ce commutateur 84 met à l'état "1" les entrées RA1 lorsque l'appareillage est en phase d'émission séquentielle ESQ et met à l'état "O" les entrées RA1 lorsque l'appareillage est en phase d'émission simultanée ESM.

L'entrée R de chaque bascule bistable $81_1$ à $81_N$ est reliée à l'un des contacts fixes d'un commutateur $85_1$ à $85_N$. La sortie Q de chaque bascule est reliée à l'un des contacts fixes d'un commutateur $86_1$ à $86_N$. Les deux autres contacts fixes d'une paire de commutateurs $85_1$—$86_1$ à $85_N$—$86_N$ sont reliés entre eux. Le contact mobile d'un commutateur, tel que $86_1$, associé à la sortie Q d'une bascule telle que $81_1$, est relié au contact mobile du commutateur, tel que $85_2$, associé à l'entrée R de la bascule suivante, telle que $81_2$. Les sorties complémentaires $\overline{Q}$ des bascules $81_1$ à $81_{N-1}$ sont reliées aux (N − 1) entrées d'une porte ET 87 dont la sortie est reliée au contact mobile du commutateur $85_1$ associé à l'entrée R de la première bascule $81_1$. Par ailleurs, la sortie Q de chaque bascule $81_1$ à $81_N$ est reliée à l'entrée $80_1$ à $80_N$ du circuit d'alimentation $73_1$ à $73_N$ de l'oscillateur associé $7_1$ à $7_N$ par l'intermédiaire d'un simple interrupteur $88_1$ à $88_N$.

De la description précédente de l'unité de commande 8, il apparaît que

a) un premier interrupteur $88_1$ à $88_N$ est fermé lorsque la fréquence de l'oscillateur associé $7_1$ à $7_N$ est sélectionnée et doit être transmise soit périodiquement soit mélangée avec les autres fréquences d'oscillateurs sélectionnés dans le premier signal composite de sortie du générateur 1;

b) lorsque le commutateur 84 sélectionne la phase d'émission simultanée ESM, au moins toutes les paires de commutateurs $85_1$—$86_1$ à $85_N$—$86_N$ correspondant aux fréquences sélectionnées par les interrupteurs fermés $88_1$ à $88_N$ courtcircuitent les bascules $81_1$ à $81_N$ afin que les circuits d'alimentation sélectionnés $73_1$ à $73_N$ alimentent simultanément les oscillateurs associés;

c) lorsque le commutateur 84 sélectionne la phase d'émission séquentielle ESQ, les contacts mobiles des commutateurs $85_1$ à $85_N$ sont reliés aux entrées R des bascules respectives $81_1$ à $81_N$ et les contacts mobiles des commutateurs $86_1$ à $86_N$ sont reliés aux sorties Q des bascules respectives $81_1$ à $81_N$ afin qu'après N périodes d'horloge T, le signal composant délivré par chacun des oscillateurs sélectionnés par les interrupteurs fermés $88_1$ à $88_N$ soit émise une fois pendant la durée d'une séquence NT. On notera que selon la variante d'émission séquentielle ESQ, les paires de commutateurs $85_1$—$86_1$ à $85_N$—$86_N$ assignés aux oscillateurs non sélectionnés peuvent courtcircuiter les bascules bistables associées. Ceci permet de réduire la séquence proportionnellement au nombre d'oscillateurs sélectionnés.

On voit également sur la figure 4 qu'un circuit de réglage d'amplitude $74_1$ à $74_N$ est relié à l'entrée d'alimentation $72_1$ à $72_N$ de chaque oscillateur $7_1$ à $7_N$. Chaque circuit $74_1$ à $74_N$ permet d'ajuster l'amplitude du signal sinusoïdal composant émis par la sortie $70_1$ à $70_N$ de l'oscillateur à une amplitude prédéterminée. Chaque circuit de réglage $74_1$ à $74_N$ inclut un commutateur $740_1$ à $740_N$ qui sélectionne l'amplitude du signal sinusoïdal composant émis en fonction du type d'émission séquentielle ESQ ou simultanée ESM afin que la diode laser fonctionne normalement. Pour chaque type d'émission l'amplitude de chaque signal sinusoïdal composant sélectionné est ajustée par un potentiomètre $741_1$ à $741_N$ ou $742_1$ à $742_N$.

Les sorties $70_1$ à $70_N$ de tous les oscillateurs sont reliées à l'entrée 20 du circuit d'émission laser 2. Ce dernier comprend, comme il est connu, une boucle de contreréaction 21 afin de régler la polarisation de la diode laser 22. Cette boucle de contre-réaction 21 est constituée par au moins une photodiode 23, qui est couplée optiquement avec la face arrière de la diode laser 22, et par un amplificateur opérationnel 24. L'amplificateur 24 fonctionne en comparateur et comporte une contre-réaction capacitive à haute fréquence 25. L'entrée directe (+) de l'amplificateur 24 est reliée à la photodiode 23 et l'entrée inverse (—) est reliée à un potentiomètre 26. Le point de fonctionnement optimal de la diode laser 22 est réglé au moyen du potentiomètre 26 afin que la diode laser soit polarisée en classe A par le courant d'excitation moyen de sa plage de fonctionnement.

En se référant à nouveau aux figures 1 et 2, on décrit maintenant le procédé de mesure de la fonction de transfert de modulation d'une fibre optique 9 de longueur prédéterminée. La mesure peut être relative à une fibre optique d'un câble à fibres optiques sur chantier ou à l'étude de l'une des caractéristiques de transmission d'une fibre optique donnée en laboratoire.

Lors de la phase d'étalonnage illustrée à la figure 1, l'embout de sortie 411 du premier connecteur 41 et l'embout d'entrée 420 du second connecteur 42 sont aboutés et alignés optiquement. L'étalonnage consiste à ajuster l'amplitude du signal électrique transmis par chaque oscillateur $7_1$ à $7_N$ du générateur à multifréquence 1 afin que toutes les raies observées à l'analyseur de spectre 6 et correspondant chacune à une fréquence composante du signal composite lumineux aient le même niveau prédéterminé PE, comme montré à la figure 3. Pour ce faire (Fig. 4) tous les commutateurs d'alimentation $88_1$ à $88_N$ sont fermés. Puis on sélectionne par exemple l'émission séquentielle ESQ au moyen des commutateurs 84, $85_1$ à $85_N$ et $86_1$ à $86_N$ de l'unité de commande 8, aux positions correspondantes précisées précédemment, ainsi qu'au moyen des commutateurs $740_1$ à $740_N$ des circuits de réglage $74_1$ à $74_N$. Les potentiomètres $741_1$ à $741_N$ permettent d'ajuster l'amplitude des signaux électriques de sortie des oscillateurs et, par suite, d'égaliser le niveau des raies composantes au niveau PE. On procède de même en inversant les commutations des commutateurs précédentes pour sélectionner l'émission simultanée ESM et pour égaliser les niveaux des raies des N fréquences composantes au niveau prédéterminé PE au moyen des potentiomètres $742_1$ à $742_N$ des circuits de réglage $74_1$ à $74_N$. On peut également procéder à ces réglages de niveau successifs en fermant un interrupteur $88_1$ à $88_N$ et en ouvrant les autres afin de sélectionner successivement la fréquence composante associée à chaque oscillateur pendant le réglage du niveau de la raie associée.

Ainsi au cours de la phase d'étalonnage, le fait d'égaliser tous les niveaux des raies aux fréquences composantes permet de s'affranchir des fonctions de transfert propres de la diode laser 22, de la fibre amorce 3 et du photodétecteur 5.

Lors de la phase de mesure illustrée à la figure 2, les extrémités de la fibre optique à mesurer 9 sont respectivement insérées dans les connecteurs 41 et 42. L'extrémité d'entrée 90 de la fibre optique 9 est insérée dans l'embout de sortie 411 du premier connecteur 41. L'extrémité de sortie 91 de la fibre optique 9 est insérée dans l'embout d'entrée 420 du second connecteur 42. Le procédé de montage des embouts dans les corps des connecteurs 41 et 42 est par exemple conforme à celui décrit dans la demande de brevet DE—B—28 26 032.4—51 déjà citée. Les positions relatives des éléments tels que diode laser 22, fibre amorce 3, connecteurs 41 et 42 photodétecteur 5, par rapport à la transmission du signal lumineux demeurent inchangées comparativement à la phase d'étalonnage montrée à la figure 1.

Selon les besoins de l'exploitation de la fibre optique 9, on procède à l'étude de la fonction de transfert et, corollairement, du coefficient d'atténuation de la fibre optique 9, relativement par exemple à une bande de fréquence prédéterminée en fermant des interrupteurs $88_1$ à $88_n$ associés aux oscillateurs $7_1$ à $7_n$ dont les n fréquences composantes associées sont incluses dans la bande de fréquence prédéterminée et en ouvrant les autres interrupteurs. La mesure peut être réalisée en émission séquentielle ESQ des fréquences composantes sélectionnées auquel cas, la diode laser 22 émet un signal lumineux qui présente une séquence égale à NT, ou de préférence égale à nT, et qui est modulé par multiplexage temporel des fréquences composantes sélectionnées émises chacune pendant une période élémentaire T d'une séquence NT ou nT. La mesure peut être également établie en émission simultanée ESM, auquel cas la diode laser 22 émet un signal lumineux qui est modulé par le mélange (multiplexage en fréquence) des n fréquences composantes sélectionnées émises simultanément. Le choix du type d'émission est sélectionné, comme déjà dit, par les commutateurs 84, $85_1$ à $85_N$, $86_1$ à $86_N$ et $740_1$ à $740_N$ du générateur à multifréquence 1.

On a représenté à la figure 3, la courbe de réponse C de la fibre optique 9 observée sur l'écran de l'analyseur de spe_ _e 6. L'axe des abscisses est relatif aux fréquences en MHz et l'axe des ordonnées aux niveaux du puissance en décibels. Les crois indiquent les niveaux aux n fréquences composantes sélectionnées. La courbe C représente les variations du module de la fonction de transfert de la fibre optique 9. L'écart A entre le niveau prédéterminé PE et le niveau de la courbe C à la plus basse fréquence représente le coefficient d'atténuation de la fibre optique 9 et est établi lors de la phase de mesure. Cette atténuation A est sensiblement égale à celle en lumière non modulée.

On notera que, dans la formulation du résultat de l'atténuation, doit être considéré, comme il est connu, la loi quadratique de détection du photodétecteur 5. Si cette loi présente des irrégularités, un tableau de correction peut être établi en étalonnant au préalable la partie réception composée des éléments 42,5 et 6 à l'aide d'un atténuateur calibré.

**Revendications**

1. Appareillage de mesure du module de la fonction de transfert d'une fibre optique (9), comprenant des moyens pour générer un premier signal électrique à fréquence variable (1), des moyens d'émission laser (2) pour convertir le premier signal électrique en un signal lumineux modulé par la fréquence variable et propre à être transmis au cours d'une phase dite de mesure à travers ladite fibre optique (9), une fibre optique amorce (3) dont l'extrémité d'entrée (30) reçoit le signal lumineux transmis par les moyens d'émission laser (2) et dont la longueur est telle que le signal lumineux transmis par son extrémité de sortie (31) soit dans les conditions d'équilibre de couplage de modes, des moyens de photodétection (5) pour convertir le signal lumineux en un second signal électrique à ladite fréquence variable et des moyens d'analyse du spectre (6) du second signal électrique qui permettent de visualiser le module de la fonction de transfert de la fibre optique (9) par mesure de la puissance du second signal électrique en fonction de ladite fréquence variable de modulation, caractérisé en ce que lesdits moyens de génération du premier signal électrique à fréquence variable (1) comprennent une pluralité d'oscillateurs (7) qui transmettent chacun aux moyens d'émission laser (2) un signal sinusoïdal à une fréquence composante prédéterminée différente de celles assignées aux autres oscillateurs pour moduler l'émission laser, et des moyens (74) commandés par tension et associés à chaque oscillateur (7) pour régler l'amplitude du signal sinusoïdal transmis par l'oscillateur associé (7) à une amplitude prédéterminée qui correspond à un niveau prédéterminé (PE) de toutes les raies de fréquence analysées par lesdits moyens d'analyse du spectre (6) du second signal électrique au cours d'une phase dite d'étalonnage pour laquelle la fibre optique à mesurer (9) n'est pas incluse dans l'appareillage.

2. Appareillage conforme à la revendication 1, caractérisé en ce que chaque oscillateur (7) comprend à sa sortie (70) reliée auxdits moyens d'émission laser (2) un circuit résonnant (71) accordé sur la fréquence prédeterminée associée.

3. Appareillage conforme à la revendication 1 ou 2, caractérisé en ce qu'il comprend des premiers moyens de commutation (88) pour sélectionner un nombre déterminé de fréquences composantes par mise sous tension des alimentations (73) des oscillateurs (7) correspondant aux fréquences composantes sélectionnées afin de mélanger simultanément lesdits signaux sinusoïdaux aux fréquences composantes sélectionnées en ledit premier signal électrique du genre à multifréquence.

4. Appareillage conforme à la revendication 1 ou 2, caractérisé en ce qu'il comporte des seconds moyens (81, 87) commandés par une horloge (82) pour sélectionner périodiquement lesdites fréquences composantes par mise sous tension successive et cyclique des alimentations (73) des oscillateurs (7) afin de multiplexer temporellement lesdits signaux sinusoïdaux aux fréquences composantes en ledit signal électrique du genre à multiplexage temporel de fréquences.

5. Appareillage conforme aux revendications 3 et 4, caractérisé en ce qu'il comprend des moyens (84, 85, 86) pour sélectionner les émissions du premier signal électrique issu du mélange simultané ou du multiplexage temporel des fréquences composantes sélectionnées.

6. Appareillage conforme à l'une des revendications 1 à 5, caractérisé en ce que les moyens d'émission laser (2) comprennent des moyens (26) insérés dans la boucle de contre-réaction (21) d'une source laser (22) convertissant le premier signal électrique en ledit signal lumineux, pour régler le courant d'excitation de la source laser afin que celle-ci soit polarisée en classe A.

7. Appareillage conforme à l'une des revendications 1 à 6, caractérisé en ce qu'il comprend un premier connecteur (41) dont l'élément d'entrée (410) est connecté à l'extrémité de sortie (31) de la fibre optique amorce (3) et dont l'élément de sortie (411) est abouté en alignement à l'élément d'entrée (420) d'un second connecteur (42) au cours de ladite phase d'étalonnage, ou est connecté à l'extrémité d'entrée (90) de la fibre optique à mesurer (9) au cours de ladite phase de mesure, et ledit second connecteur (42) dont l'élément d'entrée (420) est connecté à l'extrémité de sortie (91) de la fibre optique (9) au cours de ladite phase de mesure et dont l'élément de sortie (421) est positionné en face desdits moyens de photodétection (5).

8. Utilisation de l'appareillage selon la revendication 7 pour mesurer le module de la fonction de transfert d'une fibre optique, caractérisé en ce que la phase d'étalonnage comprend l'aboutement aligné de l'élément de sortie (411) du premier connecteur (41) et de l'élément d'entrée (420) du second connecteur (42) en vis-à-vis des moyens de photodétection (5) et l'ajustage audit niveau prédéterminé (PE) des niveaux des raies spectrales qui sont visualisées par les moyens d'analyse de spectre (6) et qui correspondent à des fréquences composantes prédéterminées du premier signal électrique, et en ce que la phase de mesure comprend l'insertion des extrémités d'entrée (90) et de sortie (91) de la fibre optique à mesurer (5) respectivement dans l'élément de sortie (411) du premier connecteur (41) et l'élément d'entrée (420) du second connecteur (42) et la sélection d'un nombre prédéterminé desdites fréquences composantes dans lesdits moyens de génération du premier signal électrique (1) afin que ce premier signal électrique soit un signal issu du mélange simultané ou du multiplexage temporel des fréquences composantes sélectionnées.

## Patentansprüche

1. Vorrichtung zum Messen des Moduls der Übertragungsfunktion einer Lichtleitfaser (9), mit einer Einrichtung (1) zum Erzeugen eines ersten elektrischen Signals mit veränderlicher Frequenz, einer Laser-Sendeeinrichtung (2) zur Umwandlung des ersten elektrischen Signals in ein durch die veränderliche Frequenz moduliertes Lichtsignal, das während einer Meßphase über die Lichtleitfaser (9) übertragen wird; mit einer Vergleichslichtleitfaser (3), deren Eingangsende (30) das von der Laser-Sendeeinrichtung (2) gelieferte Lichtsignal empfängt und deren Länge so gewählt ist, daß das an ihrem Ausgangsende (31) auftretende Lichtsignal in einem Ausgleichszustand der Wellentypkupplung ist; mit einem Photodetector (5) zur Umwandlung des Lichtsignals in ein zweites elektrisches Signal mit der veränderlichen Frequenz und mit einer Vorrichtung (6) für eine Spektralanalyse des zweiten elektrischen Signals, die den Modul der Übertragungsfunktion der Lichtleitfaser (9) durch Messen der Stärke des zweiten elektrischen Signals in Abhängigkeit von der veränderlichen Modulationsfrequenz erkennen läßt, dadurch gekennzeichnet, daß die Einrichtung (1) zur Erzeugung des ersten elektrischen Signals mit veränderlicher Frequenz mehrere Oszillatoren (7) aufweist, die jeweils mittels einer Laser-Sendeeinrichtung (2) ein sinusförmiges Signal mit einer vorgegebenen Frequenzkomponente liefert, die sich von den den anderen Oszillatoren zur Modulation der Laserstrahlung zugeordneten Frequenzkomponenten unterscheidet, und daß eine spannungsgesteuerte Einrichtung (74) jedem Oszillator (7) zur Regelung der Amplitude des von ihm erzeugten sinusförmigen Signals auf einen vorgegebenen Amplitudenwert zugeordnet ist, der einem vorgegebenen Pegel aller durch die Spektralanalysevorrichtung (6) des zweiten elektrischen Signales während einer Prüfphase, in welcher die zu messende Lichtleitfaser (9) nicht in die Vorrichtung eingegeben ist, analysierter Frequenzstrahlen entspricht.

2. Vorrichtung nach Anspruch 1, dadurch gekennzeichnet, daß jeder Oszillator (7) an seinem mit der Laser-Sendeeinrichtung (2) verbundenen Ausgang (70) eine auf die zugeordnete vorgegebene Frequenz abgestimmte Resonanzschaltung (71) aufweist.

3. Vorrichtung nach Anspruch 1 oder 2, dadurch gekennzeichnet, daß sie eine erste Schalteinrichtung (22) für die Auswahl einer bestimmten Anzahl von Frequenzkomponenten durch Unterspannungsgesetzen der Speisungen (73) der den ausgewählten Frequenzkomponenten entsprechenden Oszillatoren (7) aufweist, um gleichzeitig die sinusförmigen Signale mit den ausgewählten Frequenzkomponenten zu dem ersten mehrfachfrequenten elektrischen Signal zu mischen.

4. Vorrichtung nach Anspruch 1 oder 2, dadurch gekennzeichnet, daß sie eine zweite, durch einen Taktgeber (82) gesteuerte Einrichtung (81, 87) zum periodischen Auswählen der Frequenzkomponenten durch fortlaufendes und zyklisches Unterspannungsetzen der Speisungen (73) Oszillatoren (7) aufweist, um die sinusförmigen Signale mit den Frequenzkomponenten zu einem elektrischen Signal mit zeitlicher Frequenzmultiplexierung zu zeitmultiplixieren.

5. Vorrichtung nach Anspruch 3 und 4, dadurch gekennzeichnet, daß sie eine Einrichtung (84, 85, 86) zur Auswahl der Aussendung des ersten elektrischen, durch die gleichzeitige Mischung oder die zeitliche Multiplexierung der ausgewählten Frequenzkomponenten geschaffenen Signales aufweist.

6. Vorrichtung nach einem der Ansprüche 1 bis 5, dadurch gekennzeichnet, daß die Laser-Sendeeinrichtung (2) eine in die Gegenreaktionsschleife (21) einer das erste elektrische Signal in das Lichtsignal umwandelnden Laserquelle (22) eingefügte Einrichtungen (26) zur Regelung des Erregungsstromes der Laserquelle aufweist, um die Laserquelle in die Klasse A zu polarisieren.

7. Vorrichtung nach einem der Ansprüche 1 bis 6, dadurch gekennzeichnet, daß sie eine erste Verbindungsstufe (41), deren Eingangselement (410) mit dem Ausgangsende (31) der Vergleichs-Lichtleitfaser (3) verbunden ist und deren Ausgangselement (411) während der Prüfphase auf das Eingangselement (420) einer zweiten Verbindungsstufe (42) ausgerichtet oder während der Meßphase mit dem Eingangsende (90) der zu messenden Lichtleitfaser (9) verbunden ist, und die zweite Verbindungsstufe (42), deren Eingangselement (420) mit dem Ausgangsende (21) der Lichtleitfaser (9) während der Meßphase verbunden ist und deren Ausgangselement (421) gegenüber dem Photodetector (5) angeordnet ist, aufweist.

8. Verwendung der Vorrichtung nach Anspruch 7 zum Messen des Moduls der Übertragungsfunktion einer Lichtleitfaser, dadurch gekennzeichnet, daß in der Prüfphase das Ausgangselement (411) der ersten Verbindungsstufe (41) und das Eingangselement (420) der zweiten Verbindungsstufe (42) gegenüber dem Lichtempfänger (5) aufeinander ausgerichtet werden und die Spektralstrahlen, die durch die Spektralanalyse-Vorrichtung (6) sichtbar gemacht werden und die den vorgegebenen Frequenzkomponenten des ersten elektrischen Signales entsprechen, auf dem vorgegebenen Pegel (PE) justiert werden, und daß während der Meßphase das Eingangsende (90) und das Ausgangsende (91) der zu messenden Lichtleitfaser (5) in das Ausgangselement (411) der ersten Verbindungsstufe (41) und das Eingangselement (420) der zweiten Verbindungsstufe (42) eingesetzt werden und die Auswahl einer vorgegebenen Anzahl der Frequenzkomponenten in dieser Einrichtung (1) zur Erzeugung des ersten elektrischen Signales vorgenommen wird, damit dieses erste elektrische Signal ein durch die gleichzeitige Mischung oder die zeitweilige Multiplexierung von ausgewählten Frequenzkomponenten gebildetes Signal ist.

**Claims**

1. Apparatus for the measurement of the transfer function modulus of an optical fiber (9), comprising means for producing a first electrical signal having a variable frequency (1), laser emission means (2) for converting the first electrical signal into a light signal which is modulated by the variable frequency and adapted to be transmitted through said optical fiber (9) during a measurement phase, a priming optical fiber (3) whose entrance end (30) receives the light signal delivered from the laser emission means (2) and whose length is so that the light signal delivered from its emergent end (31) is in mode coupling balance conditions photodetection means (5) for converting the light signal into a second electrical signal having said variable frequency and means (6) for analyzing the spectrum of the second electrical signal which are adapted to display the transfer function modulus of the optical fibre (9) by measurement of the power of the second electrical signal as a function of said variable modulation frequency, characterized in that said means for producing the first electrical signal having the variable frequency (1) comprise a plurality of oscillators (7) each of which transmits to the laser emission means (2) a sinusoidal signal having a predetermined component frequency different from the frequencies assigned to the other oscillators to modulate the laser emission, and means (74) controlled by voltage and associated with each oscillator (7) for adjusting the amplitude of the sinusoidal signal which is transmitted by the associated oscillator (7), at a predetermined amplitude which corresponds to a predetermined level (PE) of all the frequency lines analyzed by said second electrical signal spectrum analyzing means (6) during a calibration phase for which the optical fiber to be measured (9) is not included in the apparatus.

2. Apparatus according to claim 1, characterized in that each oscillator (7) comprises, at its output (70) connected to said laser emission means (2), a resonant circuit (71) tuned to the associated predetermined frequency.

3. Apparatus according to claim 1 or 2, characterized in that it comprises first switch means (88) for selecting a determined number of component frequencies by applying the voltage to power supplies (73) of the oscillators (7) corresponding to the selected component frequencies so as to simultaneously mix said sinusoidal signals having the selected component frequencies into said first electrical signal arising from a frequency-division multiplexing.

4. Apparatus according to claim 1 or 2, characterized in that it comprises second means (81, 87) controlled by a clock (82) for periodically selecting said component frequencies by applying the voltage successively and cyclically to power supplies (73) of the oscillators (7) so as to time-division multiplex the component frequencies into said first electrical signal arising from a time-division multiplexing of frequencies.

5. Apparatus according to claim 3 or 4, characterized in that it comprises means (84, 85, 86) for selecting the emission of the first electrical signal arising from the simultaneous mixing or the time-division multiplexing of the selected component frequencies.

6. Apparatus according to any one of claims 1 to 5, characterized in that the laser emission means (2) comprise means (26) included in the feedback loop (21) of a laser source (22) which converts the first electrical signal into said light signal, for adjusting the excitation current of the laser source so that the laser source may be biased in class A.

7. Apparatus according to any one of claims 1 to 6, characterized in that it comprises a first connector (41) whose input terminal element (410) is connected to the emergent end (31) of the priming optical fiber (3) and whose output terminal element (411) is lined up end-to-end with the input terminal element (420) of a second connector (42) during said calibration phase, or is connected to the entrance end (90) of the optical fiber to be measured (9) during said measurement phase, and said second connector (42) whose input terminal element (420) is connected to the emergent end (91) of the optical fiber (9) during said measurement phase and whose output terminal element (421) is positioned to face of said photodetection means (5).

8. Use of the apparatus according to claim 7 for measuring the transfer function modulus of an optical fiber, characterized in that the calibration phase comprises the lined joining end-to-end of the output terminal element (411) of the first connector (41) and the input terminal element (420) of the second connector (420) positioned to face of the photodetection means (5) and the adjustment of the levels of the spectral lines at said predetermined level (PE) that are displayed by the spectrum analyzing means (6) and that correspond to predetermined component frequencies of the first electrical signal, and in that the measurement phase comprises the insertion of the entrance end (90) and the emergent end (91) of the optical fibre to be measured (9) into the output terminal element (411) of the first connector (41) and the input terminal element (420) of the second connector (42) respectively and the selection of a predetermined number of said component frequencies in said first electrical signal producing means (1) so that this first electrical signal is a signal arising from the simultaneous mixing or the time-division multiplexing of the selected component frequencies.

FIG.1

FIG.2

FIG.3

Puissance en dB

PE

A

Egalisation des raies en phase d'étalonnage.

C= niveau des raies en phase de mesure

Fréquence en MHz

GENERATEUR A MULTIFREQUENCE — CCT EMISSION LASER — Fibre amorce 3 — PHOTO-DETECTEUR — ANALYSEUR DE SPECTRE

Fibre à mesurer 9

FIG:4

UNITE DE COMMANDE

CCT EMISSION LASER
2

Q de $81_1$ à $81_{N-1}$

HORLOGE

CCT REGLAGE AMPLITUDE
$74_1$ à $74_N$

CCT ALIMENTATION $73_1$ à $73_N$

OSCILLATEURS

GENERATEUR A MULTIFREQUENCE

fibre amorce

0015830